Europäisches Patentamt

European Patent Office

Office européen des brevets

(11) Numéro de publication: **0 423 038 A1**

## (12) DEMANDE DE BREVET EUROPEEN

(21) Numéro de dépôt: 90402856.0

(22) Date de dépôt: 12.10.90

(51) Int. Cl.⁵: **G07D 7/00**, G06K 19/08, G06K 7/08, D21H 21/48

(30) Priorité: 13.10.89 FR 8913418

(43) Date de publication de la demande:
17.04.91 Bulletin 91/16

(84) Etats contractants désignés:
DE ES FR GB IT NL

(71) Demandeur: **CENTRE NATIONAL DE LA RECHERCHE SCIENTIFIQUE (CNRS)**
15, Quai Anatole France
F-75700 Paris Cedex 07(FR)

(72) Inventeur: **Jerome, Denis**
1 bis rue des Fonds
F-78350 Jouy en Josas(FR)
Inventeur: **Tevanian, Georges**
24 rue Leforestier
F-92240 L'Hay les Roses(FR)
Inventeur: **Batail, Patrick**
31 rue Bayen
F-75017 Paris(FR)
Inventeur: **Fourmigues, Marc**
74 rue de la Colonie
F-75013 Paris(FR)

(74) Mandataire: **Martin, Jean-Jacques et al**
Cabinet REGIMBEAU 26, Avenue Kléber
F-75116 Paris(FR)

(54) **Procédé d'authentification d'un objet par résonance paramagnétique électronique, appareillage pour sa mise en oeuvre et objet utilisable avec le procédé.**

(57) L'invention concerne un procédé d'authentification d'un objet spectroscopie par résonance paramagnétique électronique, caractérisé en ce qu'on ajoute à l'objet au moins une substance d'authenticité présentant une raie de RPE de largeur inférieure ou égale à environ 1,5 Gauss, en ce qu on met en oeuvre la spectroscopie sous un champ statique d'une amplitude telle que la substance présente une fréquence de résonance dans le domaine des radiofréquences, et en ce qu'on utilise comme critère de discrimination la largeur de raie.

De préférence, on superpose au champ statigne un champ de modulation colinéaire à basse fréquence d'une amplitude sensiblement supérieure à la largeur de raie de la substance et sous un champ électromagnétique radiofréquence perpendiculaire au champ statique et au champ de modulation et dont l'amplitude est égale ou supérieure à la largeur de raie, de telle manière qu'on ne détecte pas les matériaux paramagnétiques présentant une largeur de raie supérieure à celle de ladite substance.

L'invention concerne également un appareillage pour la mise en oeuvre du procédé et un papier de sécurité utilisable avec le procédé.

FIG.1

La présente invention concerne d'une façon générale le domaine de l'authentification et de l'identification, et concerne plus particulièrement un nouveau procédé pour vérifier l'authenticité d'objets et/ou les identifier, un nouvel appareillage pour la mise en oeuvre du procédé, ainsi que de nouvelles substances adaptées au procédé et à l'appareillage. Par "substance", on entend tout produit pouvant être appliqué de façon localisée sur un support ou objet quelconque, par exemple à la manière d'une encre.

Dans le domaine des papiers de sécurité ou autres, on connaît déjà de nombreuses techniques d'authentification, et en particulier la technique consistant à incorporer au papier ou à l'encre d'un billet de banque ou analogue une substance présentant une réponse spectrale particulière lorsqu'elle est soumise à un examen par résonance paramagnétique électronique (RPE) ou résonance de spin. Les brevets EP-A-0 033 994 et DK-A-147 737 sont représentatifs de l'état de la technique.

Le brevet premier cité enseigne comme substances présentant une caractéristique RPE des sels de métaux de transition et des lanthanides qui possèdent une couche 3d ou 4f imcomplète. la caractérisation de la présence de telles substances dans un papier ou analogue s'effectue par une méthode de RPE en champ élevé, de l'ordre de plusieurs dizaines de kilogauss, avec des fréquences situées dans le domaine des micro-ondes (bande X ou K). Ces substances présentent un spectre RPE comportant plusieurs raies d'une largeur individuelle de l'ordre de gauss, qui sont espacées d'une valeur déterminée qui est caractéristique de la substance employée.

Le second brevet sus-mentionné enseigne comme substances à caractéristique RPE des sels d'ions radicaux organiques appartenant à la famille des conducteurs organiques. Elles sont composées d'empilements séparés de molécules donneuses d'électrons $\Pi$ (facilement oxydables en radical cation) et de molécules acceptrices d'électrons $\Pi$ (facilement réductibles en radical anion). On peut citer par exemple le couple TTF(donneur)/TCNQ(accepteur). Le signal RPE des substances décrites dans ce brevet, détecté dans le domaine de fréquences des micro-ondes, se compose d'une raie unique caractérisée par sa position, c'est-à-dire par la valeur du champ magnétique Ho pour lequel elle apparaît, cette position de raie étant déterminée par le facteur de Landé g du système de spins de la substance en question. Et l'utilisation, comme moyen de discrimination, de ce facteur g qui varie très peu (typiquement avec un écart relatif de l'ordre de $10^{-4}$) autour de la valeur $g_e$ pour l'électron libre, impose de travailler aux fréquences les plus élevées possibles, de l'ordre de 10 à 30 GHz.

Ainsi toutes les techniques connues imposent de travailler dans le domaine des micro-ondes, c'est-à-dire avec des valeurs du champ Ho extrêmement élevées, de l'ordre de 3 à 10 kG ou davantage. Elles imposent également de travailler avec une homogénéité et une stabilité extrêmement élevées du champ Ho, de l'ordre de $\Delta H_{\frac{1}{2}}^1 / H_0$.

L'utilisation d'un champ magnétique élevé, très homogène et très stable, est cependant désavantageuse en ce qu'elle nécessite pour l'engendrer des moyens lourds et coûteux. En outre, la discrimination effectuée par les techniques connues, même sous ces champs élevés, peut s'avérer insuffisante en ce que plusieurs substances paramagnétiques différentes peuvent donner des résultats très similaires en matière de spectre de résonance.

Par ailleurs, en environnement bancaire ou analogue, une valeur élevée du champ magnétique Ho est susceptible d'effacer les informations contenues sur des supports magnétiques (tels que bandes magnétiques ou cartes bancaires) amenés au voisinage de l'appareillage de détection.

La présente invention vise à pallier ces inconvénients de la technique antérieure et à proposer un procédé et un appareillage d'authentification et/ou d'identification par résonance paramagnétique électronique qui soient à même d'effectuer une discrimination efficace entre un objet authentique et un objet non authentique, en utilisant la résonance paramagnétique électronique comme moyen de discrimination et en ne nécessitant qu'un champ statique d'amplitude modérée, sans exigence contraignante quant à la stabilité et à l'homogénéité de ce champ.

A cet effet, la présente invention concerne tout d'abord un procédé d'authentification et/ou d'idenfication d'un objet, du type dans lequel on met en oeuvre une spectroscopie par résonance paramagnétique électronique, caractérisé en ce qu'on ajoute à l'objet une quantité déterminée d'au moins une substance d'authenticité présentant une raie de résonance paramagnétique électronique de largeur inférieure ou égale à environ 1,5 Gauss, en ce qu'on met en oeuvre une spectroscopie par résonance paramagnétique électronique sous un champ magnétique statique d'une amplitude telle que la substance présente une fréquence de résonance dans le domaine des radiofréquences, et en ce qu'on utilise comme critère de discrimination la largeur de raie.

On entend ici par "radiofréquence" des fréquences situées dans la région haute de la bande VHF ou dans la région basse de la bande UHF et typiquement une fréquence inférieure ou égale à environ 1 GHz. Comme on le verra plus loin, ceci correspond à un champ statique d'une valeur inférieure ou égale à environ 370 Gauss.

De façon préférée, on superpose un champ magnétique de modulation colinéaire à basse fréquence d'une amplitude sensiblement supérieure à la largeur de raie de la substance d'authenticité et sous un champ électromagnétique radiofréquence perpendiculaire au champ statique et au champ de modulation et dont l'amplitude est égale ou supérieure à la largeur de raie, de telle manière qu'on ne détecte pas les matériaux paramagnétiques présentant une largeur de raie supérieure à celle de ladite substance.

L'invention concerne également un appareillage pour la mise en oeuvre du procédé défini ci-dessus, caractérisé sen ce qu'il comprend:
- des moyens pour créer un champ magnétique statique essentiellement homogène et constant;
- des moyens pour superposer au champ magnétique statique un champ magnétique de modulation, colinéaire, d'amplitude et de fréquence déterminées;
- des moyens pour créer un champ magnétique radiofréquence d'amplitude et de fréquence déterminées, perpendiculaire aux champs magnétiques statique et de modulation, et pour détecter les variations de ce champ,
- des moyens pour démoduler les variations détectées du champ radiofréquence et pour engendrer une information représentative de l'amplitude du signal démodulé.

L'invention concerne enfin un objet présentant une caractéristique d'authenticité, caractérisé en ce qu'il comporte une substance d'authenticité, présentant une raie étroite de résonance paramagnétique électronique, constituée par un sel de tétrahydro-1,2,7,8 dicyclopentapérylène.

D'autres aspects, buts et avantages de la présente invention apparaîtront mieux à la lecture de la description détaillée suivante d'une forme de réalisation préférée de celle-ci, donnée à titre d'exemple non limitatif et faite en référence aux dessins annexés, sur lesquels :
la figure 1 est un graphique illustrant un mode particulier de mise en oeuvre de l'invention,
la figure 2 est un schéma-bloc d'un appareillage de résonance paramagnétique électronique selon l'invention,
la figure 3 est une vue en perspective d'un détail de l'appareillage de la figure 2,
la figure 4 est une vue en coupe transversale du détail de la figure 3,
les figures 5 à 7 représentent des oscillogrammes de signaux de résonance RPE pour différentes substances,
la figure 8 est un graphique illustrant des courbes niveau de signal RPE/largeur de raie recherchée pour différentes substances, ét
la figure 9 est une vue schématique d'une variante d'appareillage.

On peut rappeler tout d'abord que la fréquence de résonance $F_1$ du spin d'un électron placé dans un champ magnétique $H_0$ est lié à ce champ par la relation :
$F_1 = g\beta H_0/h$
où $\beta$ est le magnéton de Bohr,
h est la constante de Planck,
g est le facteur de Landé, caractéristique du système de spins de la substance dont on observe la résonance.

En pratique, cette relation aboutit à une fréquence de résonance de l'ordre de 2,7 MHz par Gauss du champ $H_0$.

Conformément à la présente invention, on utilise un procédé de RPE en bas champ, avec des substances présentant une faible largeur de raie, la discrimination s'effectuant soit par élimination des largeurs de raie supérieures propres à d'autres substances RPE éventuellement présentes, soit par détermination directe de cette largeur de raie.

Plus précisément, avec des valeurs du champ $H_0$ telles que la substance RPE résonne dans le domaine des radiofréquences, et plus particulièrement de l'ordre de 50 à 370 Gauss, et des substances présentant une largeur de raie faible, typiquement comprise entre quelques dizaines de milliGauss et environ 1,5 Gauss, les avantages essentiels sont les suivants :
- l'élargissement de raie dû à l'anisotropie du facteur g (facteur de Landé de la substance considérée), en particulier dans le cas de substances sous forme de poudre, n'altère pas de manière significative la forme du signal RPE;
- pour pouvoir utiliser la largeur de raie RPE comme moyen de discrimination entre composés de susceptibilités élevées et voisines mais de largeurs de raies différentes, il suffit d'assurer une homogénéité et une stabilité du champ $H_0$ avec des écarts maximaux de l'ordre de 100 mG, c'est-à-dire une stabilité relative de l'ordre de $10^{-3}$ ou même moins, ce qui est obtenu sans difficultés techniques particulières;
- la valeur relativement faible du champ magnétique Ho peut être obtenue par des moyens simples, économiques et peu encombrants, et est sans risque pour les informations stockées sur des supports magnétiques;

3

- le fait de travailler dans le domaine des radiofréquences autorise l'emploi d'une sonde de détection de faibles dimensions, dotée d'une excellente sensibilité de détection (de par un facteur de remplissage élevé).

Dans ce contexte, une solution préférée pour obtenir et observer le signal RPE consiste en une méthode de détection transitoire, et plus précisément une méthode dite de passage rapide adiabatique.

Comme on va le voir plus loin, cette solution présente une bonne sensibilité et permet d'authentifier ou d'identifier des objets en utilisant des quantités très faibles de substance RPE. En outre, elle est particulièrement avantageuse par sa capacité à détecter les raies RPE en des durées extrêmement brèves, ce qui permet d'effectuer une authentification ou une identification efficace même dans le cas d'un mouvement relatif très rapide entre la marque RPE ajoutée à l'objet et la sonde RPE. Par ailleurs, elle permet d'effectuer une discrimination entre des substances de largeurs de raie différentes (et de susceptibilités élevées voisines) par un choix adéquat des valeurs des divers paramètres, comme on le verra plus loin. Enfin cette méthode présente également l'avantage d'être très peu exigeante quant à la stabilité et à l'homogénéité du champ statique $H_0$.

La méthode du passage rapide adiabatique produit un renversement de l'aimantation en faisant varier la valeur du champ statique $H_0$ de façon appropriée, et plus précisément en partant d'une valeur de champ $H_0$ située bien en deçà de la valeur pour laquelle se produit la résonance et en augmentant régulièrement $H_0$ avec une pulsation suffisamment lente devant $\gamma B_1$ ($\gamma$ étant le rapport gyromagnétique de la substance considérée et $B_1$ étant l'induction magnétique correspondant au champ radiofréquence $H_1$ perpendiculaire à $H_0$), mais en même temps suffisamment rapidement pour franchir la résonance en un temps très court tel que les spins n'aient pas le temps de relaxer.

En pratique, cette évolution de $H_0$ peut être réalisée en superposant au champ $H_0$, statique, un champ de modulation $H_m$ colinéaire, d'amplitude $H_m$ et de pulsation $\Omega_m$ données, ayant une forme d'onde triangulaire ou de préférence sinusoïdale. Pour réaliser la condition du passage rapide adiabatique, il faut comme on l'a indiqué ci-dessus :

$\Omega_m \ll \gamma B_1$,

L'amplitude du signal RPE observé au passage à la résonance, sur la composante de dispersion (étant donné qu'il y a saturation lorsque $H_1 > H_{\frac{1}{2}}$ pour la composante d'absorption), est proportionnelle à : $S_{adia} = \pm M_0.H_1/\sqrt{(Hm^2 + H_1{}^2)}$

avec $M_0 = \chi_0.H_0$,

et dans l'hypothèse où l'amplitude de $H_m$ est suffisamment grande devant celle de $H_1$, l'amplitude maximum observable à la résonance est proportionnelle à :

$S_{adia} \approx M_0 \approx \chi_0.H_0$. $\chi_0$ étant la susceptibilité magnétique de la substance RPE considérée.

Par ailleurs, on peut démontrer que, lorsque $H_1$ est supérieur ou égal à la largeur de raie $\Delta H_{\frac{1}{2}}$ , l'ensemble des spins interviennent dans la résonance, et l'amplitude du signal observé est maximale; si par contre $H_1$ est inférieur à cette largeur de raie, le signal RPE observé est proportionnel au rapport $H_1/\Delta H_{\frac{1}{2}}$ .

Conformément à un aspect essentiel de la présente invention, on comprend donc qu'il existe ainsi la possibilité d'effectuer une discrimination entre des substances de susceptibilités magnétiques voisines mais de largeurs de raie différentes. Plus précisément, en réglant l'amplitude du champ $H_1$ pour qu'elle soit égale ou éventuellement légèrement supérieure à la largeur de raie de la substance RPE d'authentification, le signal RPE obtenu est maximal lorsque cette substance est présente (objet authentique) et possède une amplitude plus faible lorsque cette substance est absente (objet non authentique).

On comprend donc qu'il y a un avantage particulier à utiliser une substance dont la largeur de raie soit la plus faible possible.

Par ailleurs, un autre avantage appréciable de la méthode du passage rapide adiabatique est obtenu lorsque l'on choisit pour le champ de modulation Hm une amplitude importante, et concrètement d'au moins dix fois la largeur de raie recherchée $\Delta H_{\frac{1}{2}}$ . En effet, on absorbe dans ce cas les éventuelles dérives du champ statique $H_0$. Ainsi, par exemple pour un champ statique de 100 Gauss, une dérive de 100 mGauss de ce champ n'influence pas de manière significative le signal $S_{adia}$. En pratique, on pourra admettre des variations relatives du champ statique $H_0$ de l'ordre de $10^{-3}$ sans affecter les signaux RPE obtenus.

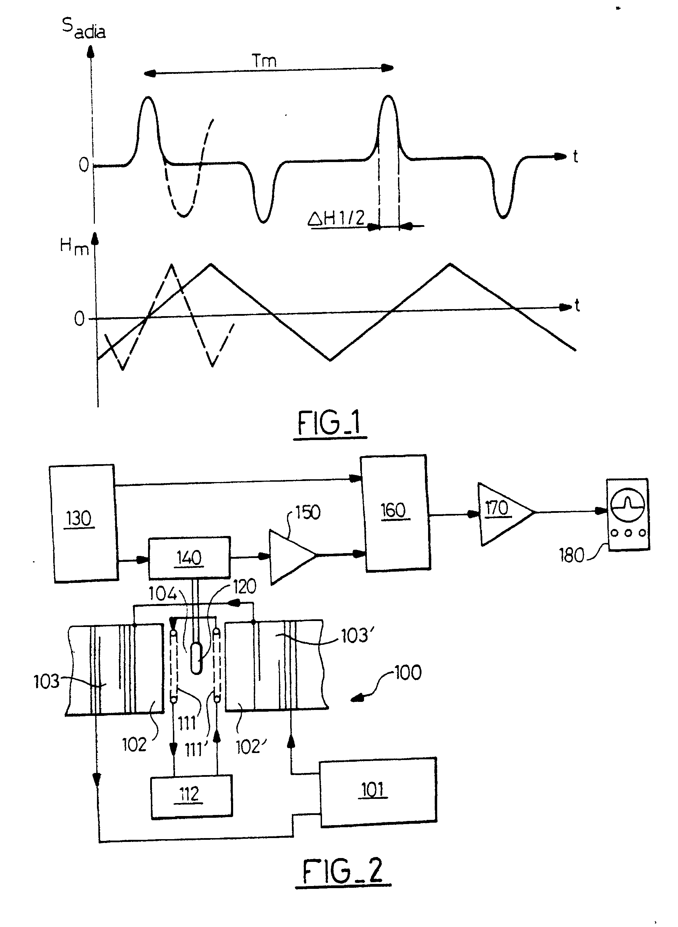

On a représenté sur la figure 1 le signal RPE $S_{adia}$ caractéristique du passage rapide adiabatique en fonction du temps, avec au dessous l'évolution du champ magnétique de modulation Hm créant ce phénomène. Le signal $S_{adia}$ illustré est en réalité l'enveloppe du signal obtenu dans la sonde RPE à la fréquence de $H_1$, et est obtenu par une démodulation d'amplitude appropriée.

La largeur à mi-hauteur $\Delta H_{\frac{1}{2}}$ du signal $S_{adia}$ (correspondant ici à une durée) ne dépend pas des temps $T_1$ et $T_2$ (qui sont les temps de relaxation spin-réseau et spin-spin, respectivement, de la substance RPE), mais seulement de l'amplitude du champ radiofréquence $H_1$ et du temps de passage à la résonance, déterminé par la pulsation $\Omega_m$. Les signaux sont positifs pour un franchissement de la résonance dans le sens montant et négatifs pour un franchissement dans le sens descendant.

Sur la figure 1, la période Tm = $2\Pi/\Omega_m$ du champ de modulation Hm est nettement supérieure à la durée des pics de résonance du signal $S_{adia}$. Et l'on comprend que, si l'on fait varier Tm de manière à ce que la fin d'un pic positif s'enchaine sans délai avec le début d'un pic négatif, et réciproquement, on observe un signal RPE essentiellement sinusoïdal, de même période que Hm.

Ce conditionnement particulier du signal $S_{adia}$ présente un grand intérêt car son spectre de fréquence se réduit à une composante unique à la fréquence $\Omega_m/2\Pi = 1/Tm$.

Il est particulièrement intéressant dans ce cas d'utiliser dans les moyens de traitement du signal $S_{adia}$ un filtrage adapté, techniquement simple à réaliser, lors de l'amplification du signal après sa démodulation. Plus précisément, un filtre passe/bande centré sur la fréquence 1/Tm va améliorer considérablement le rapport signal/bruit du signal $S_{adia}$, sans pour autant atténuer l'amplitude du signal.

Par ailleurs, dans le cas où la substance RPE à observer passe dans la sonde RPE à une vitesse élevée, il est simplement nécessaire que la période de modulation Tm du champ H0 soit très inférieure à la durée de résidence de ladite substance dans la sonde, afin d'observer pendant cette durée de résidence un nombre de cycles de renversement de l'aimantation suffisant pour détecter convenablement la substance. Par exemple, supposons que Tm = 28 $\mu$s et que la substance RPE soit sous forme d'une marque de 3 mm de diamètre sur un objet, avec une vitesse relative de 8 m/s entre la sonde et l'objet. La durée de résidence est alors de 375 $\mu$s, si bien que l'on pourra observer plus de 13 cycles de renversement de l'aimantation pendant le passage. La technique du passage rapide adiabatique est donc particulièrement bien adaptée à la détection de marques RPE circulant à très grande vitesse dans la sonde.

A cet égard, on notera ici que cette méthode de détection en régime adiabatique conserve ses avantages lorsqu'on utilise une technique de détection en haut champ. Plus précisément, en haut champ également, la méthode du passage rapide adiabatique permet de détecter des marques de petites dimensions en des temps très courts, d'où la posibilité là aussi de faire circuler les objets portant les marques à grande vitesse dans la sonde.

On va décrire ci-dessous accessoirement une autre méthode de détection selon l'invention, dite méthode en régime permanent, selon laquelle, en plus de la modulation du champ H0 par un champ colinéaire Hm, on effectue un balayage très lent du champ H0 en lui superposant en outre un champ alternatif Hb de période Tb donnée, de manière à faire passer H0 + Hb par une valeur qui provoque la résonance. La valeur maximale du signal RPE noté S est proportionnelle à $\chi_0.H_0$.

L'utilisation d'une détection synchrone permet l'observation du signal dérivé S' dont l'amplitude est égale à $S/\Delta H^1_{\frac{1}{2}}$, ce signal dérivé étant donc d'autant plus intense que la raie est étroite. L'avantage additionnel obtenu dans ce cas est que ce signal renseigne directement sur la valeur de la largeur de raie, même élargie. Plus précisément, en choisissant la fréquence de modulation Fm = 1/Tm inférieure à $1/T_2$, $T_2$ étant le temps de relaxation spin-spin du système de spins considéré, en réglant l'amplitude de Hm précisément sur le double de la largeur de raie $\Delta H^1_{\frac{1}{2}}$ du composé à observer, et en réglant l'amplitude de Hb sur une valeur de l'ordre de dix fois cette largeur $\Delta H^2_{\frac{1}{1}}$, on peut démontrer qu'on observe directement, après démodulation appropriée, le signal RPE d'absorption.

On peut utiliser avantageusement la méthode en régime permanent, moins rapide que la méthode adiabatique du fait de la modulation très lente par Hb, lorsque d'une part les objets à authentifier sont fixes ou en déplacement lent par rapport à la sonde RPE, et d'autre part lorsque l'on souhaite obtenir directement la valeur de la largeur de raie de la substance.

On va décrire ci-dessous en référence aux figures 2 à 4 un exemple de réalisation possible d'un appareillage de détection par résonance paramagnétique électronique adapté à la mise en oeuvre de la technique adiabatique décrite plus haut.

L'appareillage comporte des moyens pour :
- engendrer un champ statique H0, avec une stabilité et une homogénéité relatives de l'ordre de $10^{-3}$ ou mieux:
- engendrer un champ de modulation Hm d'amplitude, de fréquence et de forme d'onde données, colinéaire au champ statique H0;
- engendrer un champ radiofréquence H1 d'amplitude et de fréquence données, perpendiculaire aux champs H0 et Hm; et
- détecter un signal de résonance RPE.

Par ailleurs, dans le présent exemple, on permet le passage dans la sonde RPE de tout objet mince à authentifier ou à identifier avec une vitesse donnée dans une direction incluse dans son plan.

Pour ce qui concerne le champ H0, et en référence à la figure 2, une solution possible consiste à utiliser le champ régnant dans l'entrefer d'un circuit magnétique, globalement indiqué en 100, polarisé en continu par une source de courant continu réglable 101. Le circuit magnétique comprend ici deux noyaux de ferrite 102, 102' définissant entre eux un entrefer 104 et sur lesquels sont enroulées des bobines 103, 103'. Avec de tels moyens, l'obtention d'un champ de l'ordre de 50 Gauss avec une homogénéité de l'ordre de $10^{-3}$ dans un volume correspondant au lieu de passage de la marque RPE, c'est à dire dans un volume centré sur quelques millimètres carrés au milieu de l'entrefer 104, ne pose pas de difficulté. En variante, on peut également utiliser un aimant permanent.

Par exemple, on peut prévoir un entrefer de 10 mm de large, avec des faces polaires des noyaux d'un diamètre de 30 mm et présentant un parallélisme mutuel de l'ordre de 10 $\mu$m et un très bon état de surface.

Le champ de modulation $H_m$ est par exemple produit par une paire de bobines d'Helmholtz 111,111' placées dans l'entrefer 104 du circuit magnétique 100. On peut rappeler ici qu'une paire de bobines d'Helmholtz est consituée par deux bobines d'axes confondus, de même rayon R et distantes de la valeur de R. Les bobines 111,111' sont alimentées par un générateur basse fréquence 112 capable de délivrer un signal sinusoïdal ou triangulaire d'amplitude réglable et de fréquence fixe (lorsqu'une seule substance RPE est à détecter) ou réglable (lorsque plusieurs substances RPE de caractéristiques différentes doivent être détectées individuellement). Par exemple, le générateur 112 délivre une fréquence de l'ordre de 35 kHz.

Le champ radiofréquence $H_1$ doit être perpendiculaire aux deux champs précédents. Cela exclut donc l'utilisation d'une bobine conventionnelle, car celle-ci, disposée transversalement à la direction de passage d'un billet ou autre support, interdirait un tel passage.

Ainsi, selon un autre aspect essentiel de la présente invention, et maintenant en référence aux figures 2 à 4 conjointement, on utilise pour établir le champ $H_1$ une ligne bifilaire adaptée en court-circuit, globalement indiquée en 120.

Il est bien connu dans la théorie que, lorsqu'une ligne bifilaire adaptée de longueur $l = \lambda/4$, $\lambda$ étant la longueur d'onde du rayonnement à émettre, est en court-circuit, elle se comporte comme un résonateur pour cette longueur d'onde en étant le siège d'ondes stationnaires de courant et de tension qui donnent naissance d'une part à un champ électrostatique E orienté dans une direction contenue dans le plan des deux conducteurs et perpendiculaire à ces conducteurs, et d'autre part à un champ magnétique $H_1$ perpendiculaire à E, comme illustré. Le courant, et donc le champ $H_1$, sont maximaux au voisinage du court-circuit.

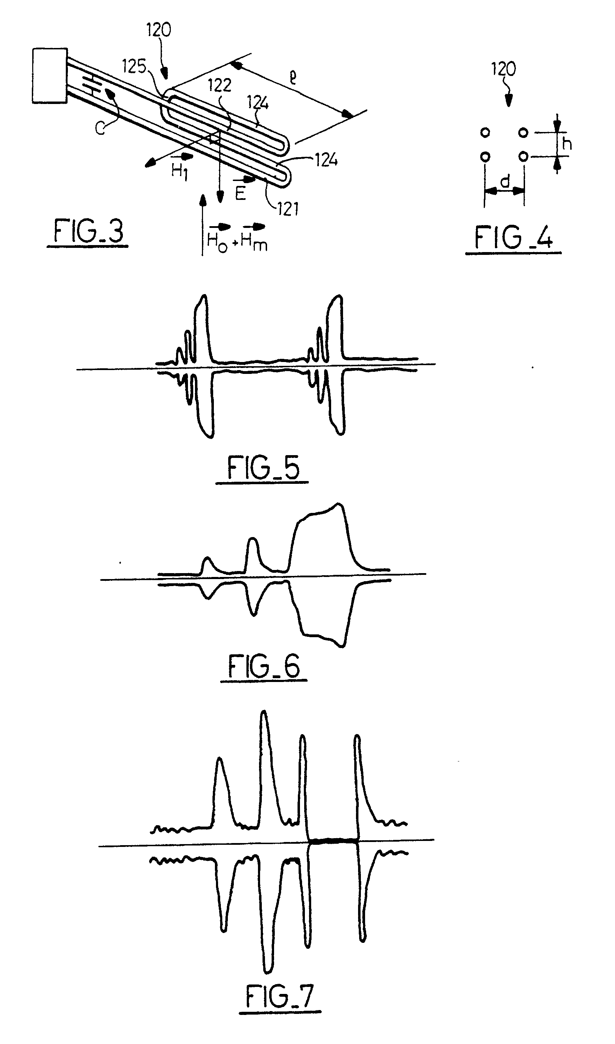

D'autre part, on peut facilement réduire la longueur du résonateur tout en continuant à la faire résonner à la longueur d'onde $\lambda$; il suffit en effet de compenser le déficit capacitif ainsi créé par un condensateur externe, indiqué en C sur la figure 3.

La solution décrite ci-dessus présente plusieurs avantages :
- le résonateur (l'équivalent d'une "cavité résonante" dans des fréquences de micro-ondes) est réalisé dans un volume très réduit;
- le courant, et donc le champ $H_1$, sont maxima et pratiquement constants en tout point qui est éloigné du court-circuit d'une distance inférieure à 1/10è de la longueur $l$ du résonateur;
- le champ électrostatique est pratiquement nul dans cette région; on minimise ainsi les pertes diélectriques occasionnées par le passage des objets à authentifier;
- le passage pour des objets minces est libéré.

Ces avantages sont obtenus en pliant le bout de ligne en court-circuit à 180°, comme représenté sur la figure 3, de manière à obtenir une configuration analogue à celle d'un trombone. Ainsi la ligne 120 comporte une première partie constituée des sections de fil 121 et 122, un coude à 180° (vers l'arrière sur la figure 3), une seconde partie constituée des sections de fil 123 et 124, parallèles aux premières et qui se terminent par le court-circuit 125.

Des valeurs préférées, mais non limitatives, pour les distances $l$, h et d représentées sur les figures 3 et 4 sont $l = 10$ mm, h = 1 mm et d = 4 mm.

Dans une variante de réalisation non illustrée, les différentes sections conductrices du résonateur 120 peuvent être réalisées sous forme de pistes conductrices disposées de façon appropriée sur un substrat souple, qui est ensuite convenablement replié à 180° sur lui-même pour définir le résonateur. L'objet à authentifier est acheminé par des moyens de transport conventionnels entre les deux branches du substrat.

Dans une autre variante encore, on peut utiliser de plaquettes de circuits imprimées disposées parallèment l'une à l'autre avec un faible écartement.

Comme le montre schématiquement la figure 2, ce résonateur ou sonde 120 est placé dans l'entrefer 104 de telle sorte que chaque section de conducteur 121 à 124 est parallèle aux faces des noyaux 102, 102', pour ainsi créer un champ $H_1$ perpendiculaire au plan de la feuille du dessin, et donc à $H_0$ et Hm.

La détection du signal RPE est assurée par le résonateur décrit ci-dessus, et plus précisément en recueillant la tension V présente aux bornes du résonateur, qui donnera après traitement approprié le signal $S_{adia}$.

Ce signal est maximum, et noté dans ce cas $V_{max}$, lorsque l'amplitude de $H_1$ est choisie égale à la largeur de raie de la substance RPE choisie, comme on l'a vu plus haut.

On a

$V_{max} = \chi_0.H_0.\omega_1.\eta.Q.A$

où

$\eta$ est le coefficient de remplissage, c'est-à-dire le rapport entre le volume de l'échantillon ou de la marque de substance RPE et le volume du résonateur 120, Q est le facteur de qualité du résonateur, et A est l'aire traversée par le flux magnétique, c'est-à-dire la section droite du résonateur.

De retour à la figure 2, l'appareillage comprend en outre une source radiofréquence 130 qui délivre en sortie un signal sinusoïdal de fréquence $f_1 = \omega_1/2\Pi$, qui peut être réglé en amplitude et en fréquence pour ainsi déterminer l'amplitude et la fréquence du champ radiofréquence $H_1$.

Le résonateur 120 est relié à la source 130 via un pont hybride $180°$ indiqué en 140, qui délivre directement un signal à la fréquence f exhibant la variation de tension V produite au passage à la résonance.

Ce signal issu du pont hybride est amplifié dans un amplificateur HF à large bande 150, d'un gain par exemple de l'ordre de 30 dB, et appliqué à l'entrée d'un détecteur de phase 160 pour y être démodulé. L'entrée locale du détecteur de phase 160 est à cet effet reliée à une sortie de la source radiofréquence 130.

Le signal démodulé en 160 est ensuite appliqué à l'entrée d'un amplificateur sélectif 170 de gain élevé, par exemple de l'ordre de 90 à 100 dB. Le filtrage effectué par cet amplificateur est un filtrage passe-bande réglé sur la fréquence du champ magnétique de modulation Hm, et son facteur de qualité Q est volontairement limité à une valeur moyenne, de l'ordre de 30 à 40, de tels sorte que la constante de temps obtenue soit compatible avec la brève durée de passage d'une marque de substance RPE de 3 mm de diamètre passant dans le résonateur à la vitesse de 8 m/s.

Dans l'appareillage expérimental décrit ci-dessus, l'observation des signaux se fait à l'aide d'un oscilloscope 180. Cependant, dans la pratique, l'oscilloscope est remplacé par un circuit électronique, par exemple un circuit de détection à seuil qui, en déterminant si les impulsions fournies par l'amplificateur 170 ont une amplitude supérieure ou non à une valeur préétablie, va indiquer si l'objet marqué acheminé à travers la sonde possède la marque RPE d'authenticité ou non.

Essais

Des tests ont été réalisés sur des échantillons de papier enduit d'une encre confectionnée à partir de cristaux de sels de dicyclopentapérylène (CPP), une fois réduits en une poudre d'une granulométrie de 40 $\mu$m et enrobés dans un véhicule dans une proportion de 20% en poids.

Deux échantillons, l'un en forme de disque de 3,5 mm de diamètre et l'autre en forme d'un rectangle de 2 mm x 4 mm, équivalents respectivement à 70 $\mu$g et 150 $\mu$g de substance active, ainsi qu'une bande témoin de papier vierge, ont été apposés sur la périphérie d'un disque support en matériau isolant, d'un diamètre de 38 cm et d'une épaisseur de 0,5 mm, entraîné en rotation à une vitesse de 100 tours/seconde, de manière à déplacer les échantillons et la bande témoin à une vitesse de 7,6 m/s. On a ainsi simulé les conditions de passage rapide d'un support en papier ou analogue, portant une marque RPE, dans une machine d'authentification.

Le disque support a été placé dans l'entrefer de la sonde RPE décrite plus haut.

Les conditions expérimentales étaient les suivantes:

| | |
|---|---|
| champ statique | $H_0 = 74,6$ Gauss |
| radiofréquence | $f = 209$ MHz |
| fréquence de modulation | $1/Tm = 35$ kHz |
| amplitude du champ de modulation | $Hm = 400$ mGauss |
| champ d'excitation/détection | $H_1 \approx 50$ mGauss |
| largeur de raie du CPP | $\Delta H_{\frac{1}{2}} = 26$ mGauss |

L'oscillogramme de la figure 5 montre deux séries espacées dans le temps de signaux de résonance RPE, consécutifs à une révolution complète du disque. Les figures 6 et 7 sont des oscillogrammes dilatés de ces mêmes signaux.

On peut observer trois raies correspondant respectivement à la bande témoin, à l'échantillon à 70 $\mu$g et à l'échantillon à 150 $\mu$g.

Pour l'échantillon à 70 $\mu$g, on note un rapport signal/bruit d'environ 7, ce qui situe le bruit à environ 10 $\mu$g équivalent de substance.

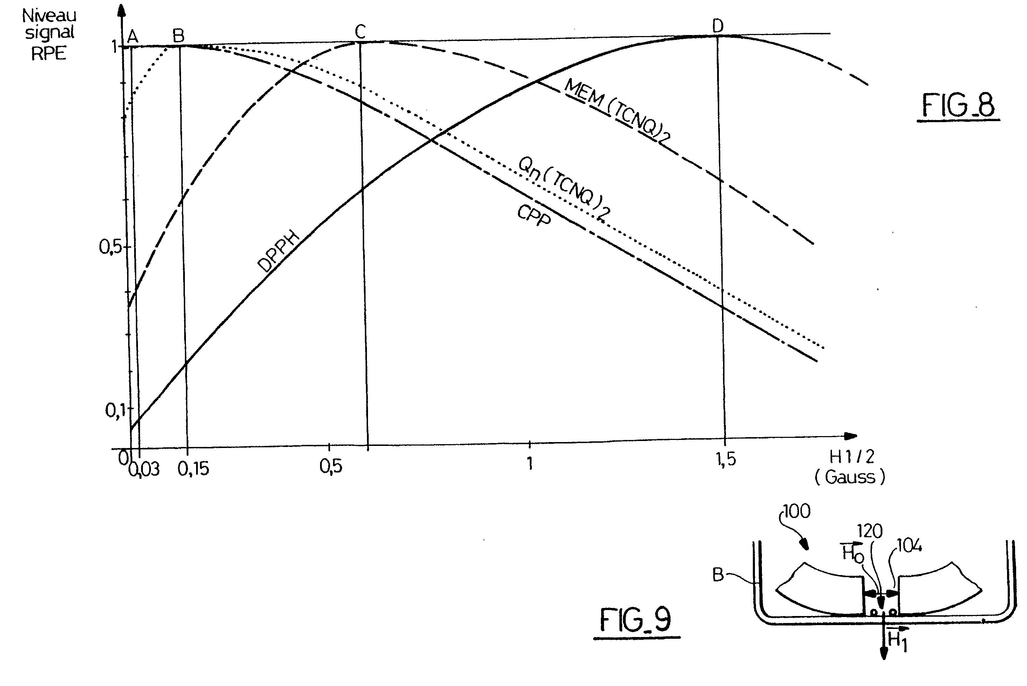

On a représenté sur la figure 8 un diagramme illustrant le comportement d'un certain nombre de substances à faible largeur de raie RPE et, en corollaire les possibilités de discrimination entre ces substances.

Comme on l'a indiqué plus haut, en régime de passage rapide adiabatique, les conditions d'observations d'un signal RPE d'amplitude maximale pour une substance donnée dépendent essentiellement :
- de l' amplitude du champ radiofréquence $H_1$, qui doit être supérieure à $\Delta H_{\frac{1}{2}}$,
- de l'amplitude du champ de modulation Hm, qui doit être supérieure à $10\Delta H_{\frac{1}{2}}$, - du temps de passage à la résonance, déterminé par la pulsation $\Omega$, qui doit être supérieur aux temps de relaxation $T_1$ et $T_2$.

A des substances de largeur de raie différente correspondent donc des couples de valeurs optimales $H_1$ et Hm pour l'observation d'un signal RPE maximum.

L'étude de l'évolution de la réponse d'une substance de largeur de raie donnée, pour un ensemble de couples $H_1$, Hm adaptés respectivement à des substances de largeurs de raie différentes, met en évidence les possibilités de discrimination du capteur.

Ainsi la figure 8 porte en abcisse la largeur de raie $\Delta H_{\frac{1}{2}}$, déterminée en réalité par un ensemble de couples de valeurs optimales $H_1$, Hm, et en ordonnée l'amplitude du signal $S_{adia}$.

Par ailleurs, les courbes correspondant aux réponses pour les différentes substances ont été normalisées (tous les maxima portés à 1), concrètement en utilisant pour chaque substance une quantité inversement proportionnelle à sa susceptibilité magnétique.

Les conditions optimales pour chaque substance, matérialisées sur la figure 8 par des repères A, B, C et D, sont les suivantes :

| Substance | Hm(mV) | $H_1$ (dB) | $\Delta H_{\frac{1}{2}}$ (mGauss) |
|---|---|---|---|
| A $(CPP)_2PF_6$ [1] | 20 | 4 | 30 |
| B $Q_n(TCNQ)_2$ [2] | 30 | 5 | 150 |
| C $MEM(TCNQ)_2$ [3] | 70 | 10 | 600 |
| D $DPPH$ [4] | 300 | 16 | 1500 |

[1]: sel de tétrahydro-1,2,7,8 dicyclopentapérylène
[2]: quinolinium(tétracynoquinodiméthane)$_2$
[3]: Méthyl-éthyl-morpholinium(tétracynoquinodiméthane)$_2$
[4]: $\alpha,\alpha$-diphényl-$\beta$-picryl-hydrazyle

La valeur du champ Nm est déterminée par l'amplitude indiquée en mV de la tension appliquée à la bobine d'Helmholtz; le champ $H_1$ est évalué en dBm, avec odBm = 1 mW dans 50 $\Omega$.

Comme on l'observe sur la figure 8, pour les conditions optimales correspondant au $(CPP)_2PF_6$ (cas A), la réponse des autres substances est :
$Q_n (TCNQ)_2$ : 0,85
$MEM(TCNQ)_2$ : 0,4
DPPH : 0,1

De même, pour les conditions optimales correspondant au DPPH (cas D), la réponse des autres substances est :
$(CPP)_2PF_6$ : 0,35
$Q_n (TCNQ)_2$ : 0,4
$MEM(TCNQ)_2$ : 0,65

On démontre ainsi qu'il est possible, du fait de leurs largeurs de raie différentes, d'effectuer une discrimination fiable entre par exemple le $(CPP)_2PF_6$ et le DPPH.

Par ailleurs, on peut également de façon avantageuse utiliser un mélange de deux substances de largeurs de raie différentes, avec la possibilité de les discriminer par rapport à d'autres substances de largeur de raie supérieure ou intermédiaire. Dans un premier cas, les deux substances ont chacune une largeur de raie inférieure ou égale à environ 1,5 Gauss; dans un second cas, l'une des substances possède une largeur de raie inférieure à environ 1,5 Gauss et l'autre possède une largeur de raie supérieure à cette valeur.

On a décrit plus haut une sonde de détection RPE dans laquelle peuvent être amenés à circuler des objets minces, pour authentification ou identification.

On va maintenant décrire en référence à la figure 9 une autre réalisation d'une sonde RPE à bas champ, permettant d'opérer des détections de marques RPE sur des objets de natures, de formes et de dimensions tout à fait quelconques.

Sur la figure 9, des éléments ou parties identiques ou similaires à ceux des figures 2 à 4 sont désignés par les mêmes numéros de référence.

Le champ $H_0 + H_m$ est établi dans l'entrefer d'un circuit magnétique 100 de type quelconque, tandis que le champ électromagnétique $H_1$ est établi par une ligne bifilaire en court-circuit 120 résonnant à la fréquence de $H_1$ et contenue dans un plan parallèle au champ statique et situé au voisinage du bord inférieur de l'entrefer. Ces moyens pour établir les champs, ainsi que toute la circuiterie électronique associée, sont contenus par exemple dans un boîtier portatif B dont une paroi très mince (de préférence fraction de millimètre), inerte vis-à-vis des champs électromagnétiques, et par exemple en matière plastique, vient se placer à proximité du bord inférieur de l'entrefer et de la ligne bifilaire 120.

Une autre solution peut consister à utiliser une technologie inspirée des têtes de lecture magnétique.

La sonde portative ainsi réalisée peut être utilisée pour "lire" des marques paramagnétiques rapportées à la surface d'objets de types tout à fait quelconques. Sa sensibilité est moins bonne que celle des figures 2 à 4, du fait que la marque RPE ne peut venir se situer que dans une zone où le champ statique $H_0$ n'est pas rigoureusement homogène et où le champ $H_1$ est d'amplitude affaiblie, mais . reste amplement suffisante pour effectuer de telles lectures. En pratique, il suffit d'utiliser dans les marques une quantité de substance supérieure à celle qui est nécessaire avec la sonde des figures 2 à 4 et typiquement de l'ordre de 100 à 500 $\mu$g.

Des substances RPE de type tout à fait quelconque peuvent être utilisées dans le cadre de la présente invention, pour autant qu'elles aient une largeur de raie relativement étroite, typiquement inférieure ou égale à 1,5 Gauss et une susceptibilité $\chi_0$ élevée. On peut citer les matériaux organiques cristallins à caractéristique de conducteur métallique, de semi-conducteur ou d'isolant.

Par ailleurs, les objets authentifiables ou identifiables avec le procédé de la présente invention peuvent être de type tout à fait quelconque : papier de sécurité, et notamment papier fiduciaire, cartes bancaires, objets d'art ou objets précieux, etc...

La ou les marques RPE ajoutées à l'objet peuvent également se présenter sous diverses formes; dans le cas d'un papier, carton ou autre, la substance RPE peut être localement incorporée dans la masse; on peut également l'incruster ponctuellement à la surface d'un objet, par des moyens mécaniques, thermiques, etc...

Par ailleurs, le procédé de la présente invention peut également être utilisé à des fins d'identification, en prévoyant une pluralité de marques RPE disposées de façon bien déterminée; par exemple les marques RPE peuvent être disposées de façon analogue à un code à barres. Dans ce cas, le code est lu soit lors du passage de l'objet dans une sonde fixe par exemple du type décrit en référence aux figures 2 à 4, soit encore, avec une sonde portative du type de celle de la figure 9, par déplacement de la sonde sur la surface de l'objet, fixe. L'amplitude du signal de sortie des moyens de traitement, évoluant en fonction de la répartition des zones paramagnétiques et non paramagnétiques du marquage, servira de base à un décodage approprié en vue de la restitution de l'information codée.

Une façon particulièrement avantageuse de réaliser un tel code à barres ou code similaire peut être basée sur le fait qu'un certain nombre de substances RPE perdent définitivement leurs propriétés paramagnétiques lorsqu 'elles sont échauffées à un degré donné, variable selon les substances.

Ainsi il est possible conformément à l'invention de réaliser une marque unique de substance RPE, de dimensions relativement grandes, et de sélectivement "brûler" la substance dans des zones prédéterminées de la marque pour ainsi neutraliser ses propriétés dans ces zones, lesdites propriétés étant conservées dans les autres zones.

Cette neutralisation sélective, correspondant à une véritable écriture du code, peut être effectuée par exemple à l'aide d'un faisceau Laser ou analogue.

Un avantage des codes à barres paramagnétiques par rapport aux codes à barres traditionnels à lecture optique réside en que le code peut ici être masqué. Ainsi un masquage visuel, à l'aide d'une peinture ou analogue présentant le même aspect que la substance RPE, permet d'éviter que le marquage RPE soit observé à l'oeil. Par ailleurs, un masquage paramagnétique par une couche d'une autre substance RPE, présentant un facteur de Landé semblable mais une largeur de raie sensiblement supérieure, ne permet l'identification qu'en réglant l'appareillage RPE sur la largeur de raie la plus étroite, pour ainsi lire le code apposé sans que l'efficacité ou la vitesse de lecture ne soient d'une quelconque manière compromises.

Bien entendu, la présente invention n'est nullement limitée à la forme de réalisation décrite ci-dessus et représentée sur les dessins, mais l'homme de l'art saura y apporter toute variante ou modification conforme à son esprit.

**Revendications**

1. Procédé d'authentification et/ou d'idenfication d'un objet, du type dans lequel on met en oeuvre une spectroscopie par résonance paramagnétique électronique, caractérisé en ce qu'on ajoute à l'objet une quantité déterminée d'au moins une substance d'authenticité présentant une raie de résonance paramagnétique électronique de largeur ($\Delta H\frac{1}{2}$) inférieure ou égale à environ 1,5 Gauss, en ce qu'on met en oeuvre une spectroscopie par résonance paramagnétique électronique sous un champ magnétique statique ($H_0$) d'une amplitude telle que la substance présente une fréquence de résonance dans le domaine des radiofréquences, et en ce qu'on utilise comme critère de discrimination la largeur de raie.

2. Procédé selon la revendication 1, caractérisé en ce qu'on superpose au champ magnétique statique ($H_0$) un champ magnétique de modulation colinéaire ($H_m$) à basse fréquence d'une amplitude sensiblement supérieure à la largeur de raie de la substance d'authenticité et sous un champ électromagnétique radiofréquence ($H_1$) perpendiculaire au champ statique et au champ de modulation et dont l'amplitude est égale ou supérieure à la largeur de raie, de telle manière qu'on ne détecte pas les matériaux paramagnétiques présentant une largeur de raie supérieure à celle de ladite substance.

3. Procédé selon l'une des revendications 1 et 2, caractérisé en ce qu'on ajoute à l'objet des quantités déterminées de deux substances d'authenticité de largeurs de raies toutes deux inférieures ou égales à environ 1,5 Gauss mais sensiblement différentes l'une de l'autre.

4. Procédé selon l'une des revendications 1 et 2, caractérisé en ce qu'on ajoute à l'objet des quantités déterminées de deux substances d'authenticité de largeurs de raies respectivement sensiblement supérieure à environ 1,5 Gauss et inférieure ou égale à environ 1,5 Gauss.

5. Procédé selon l'une des revendications 1 à 4, caractérisé en ce que l'amplitude du champ de modulation ($H_m$) est choisie au moins 10 fois supérieure à la largeur de raie de la ou de l'une des substances d'authenticité.

6. Procédé selon l'une des revendications 1 à 5, caractérisé en ce que la période ($\Omega_m$) du champ de modulation est choisie sensiblement égale au temps de relaxation spin-spin ($T_2$) de la ou de l'une des substances d'authenticité.

7. Procédé selon l'une des revendications 1 à 6, caractérisé en ce qu'on effectue la spectroscopie à l'aide d'une sonde pendant que la sonde et l'objet sont en déplacement relatif.

8. Procédé selon la revendication 7, rattachée à la revendication 6, caractérisé en ce que l'on choisit les dimensions de la zone comportant la substance d'authenticité et la vitesse de déplacement entre la sonde et l'objet de telle façon que la durée de séjour de la substance dans la sonde soit sensiblement supérieure à la période ($\Omega_m$) du champ de modulation ($H_m$).

9. Procédé selon l'une des revendications 1 à 8, caractérisé en ce qu'on ajoute la substance d'authenticité à l'objet par application en surface.

10. Procédé selon l'une des revendications 1 à 8, caractérisé en ce qu'on ajoute la substance d'authenticité à l'objet par incorporation dans la masse.

11. Procédé selon l'une des revendications 1 à 10, caractérisé en ce qu'on ajoute la substance d'authenticité à l'objet sous forme d'une marque essentiellement discrète.

12. Procédé selon l'une des revendications 1 à 10, caractérisé en ce qu'on ajoute la substance d'authenticité à l'objet sous la forme d'une pluralité de marques disposées de manière à définir un code d'identification de l'objet.

13. Procédé selon la revendication 12, caractérisé en ce qu'on forme la pluralité de marques en formant tout d'abord une zone unique et essentiellement homogène de substance d'authenticité puis en altérant par voie thermique les propriétés paramagnétiques de la dite substance dans des parties prédéterminées de ladite zone, pour ne laisser la substance intacte qu'au niveau desdites marques.

14. Procédé selon la revendication 13, caractérisé en ce qu'on effectue l'altération par voie thermique à l'aide d'un rayonnement Laser.

15. Procédé selon l'une des revendications 11 à 14, caractérisé en ce que la ou les marques sont revêtues d'un masquage visuel.

16. Procédé selon l'une des revendications 11 à 14, caractérisé en ce que la ou les marques sont revêtues d'un masquage paramagnétique comprenant un matériau présentant une raie de résonance paramagnétique électronique sensiblement plus large que la largeur de raie de la substance d'authenticité et un facteur de Landé voisin de celui de la substance d'authenticité.

17. Appareillage pour la mise en oeuvre du procédé selon la revendication 2, caractérisé en ce qu'il comprend:

- des moyens (100,101) pour créer un champ magnétique statique essentiellement homogène et constant;
- des moyens (111,111',112) pour superposer au champ magnétique statique un champ magnétique de modulation, colinéaire, d'amplitude et de fréquence déterminées;
- des moyens (120,130,140) pour créer un champ magnétique radiofréquence d'amplitude et de fréquence déterminées, perpendiculaire aux champs magnétiques statique et de modulation, et pour détecter les variations de ce champ,
- des moyens (150,170,180) pour démoduler les variations détectées du champ radiofréquence et pour engendrer une information représentative de l'amplitude du signal démodulé.

18. Appareillage selon la revendication 17, caractérisé en se que les moyens pour créer un champ magnétique radiofréquence comprennent une ligne bifilaire adaptée en court-circuit (120) située dans l'entrefer d'un circuit magnétique, dans lequel sont établis le champ statique et le champ de modulation.

19. Appareillage selon la revendication 18, caractérisé en ce qu'il se présente sous la forme d'une sonde portative dans une région de bord de laquelle sont disposés la ligne bifilaire et l'entrefer.

20. Appareillage selon la revendication 18, caractérisé en ce que la ligne bifilaire est repliée à 180° sur elle-même, un objet mince pouvant être amené à circuler entre ses branches repliées.

21. Objet présentant une caractéristique d'authenticité, caractérisé en ce qu'il comporte une substance d'authenticité, présentant une raie étroite de résonance paramagnétique électronique, constituée par un sel de tétrahydro-1,2,7,8 dicyclopentapérylène.

FIG.1

FIG.2

FIG.3

FIG.4

FIG.5

FIG.6

FIG.7

FIG.8

FIG.9

EP 0 423 038 A1

Office européen
des brevets

**RAPPORT DE RECHERCHE
EUROPEENNE**

Numéro de la demande

**EP 90 40 2856**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. CI.5) |
|---|---|---|---|
| Y,A | DE-A-3 408 086   (SODECO-SAIA)<br>* abrégé; revendications 1-13; figures 1, 2 * * page 8, ligne 18 - page 11, ligne 19 *<br>— — — | 1,17,2,7, 9,11,12, 18-20 | G 07 D<br>7/00<br>G 06 K 19/08<br>G 06 K 7/08 |
| Y | MEASUREMENT AND CONTROL. vol. 21, no. 3, avril 1988, LONDON GB pages 83 - 86; R. LADBURY: "Electron Spin Resonance"<br>* page 85, colonne 3 - page 86, colonne 1; figure 1 *<br>— — — | 1,17 | D 21 H 21/48 |
| D,A | EP-A-0 033 994   (PAPIERFABRIEKEN VAN HOUTUM & PALM)<br>* abrégé; revendications 1-10; figure 1 *<br>— — — — — | 1,3,4,10 | |

| DOMAINES TECHNIQUES RECHERCHES (Int. CI.5) |
|---|
| G 07 D<br>G 07 F<br>B 44 F<br>B 42 D<br>G 06 K<br>D 21 H<br>G 01 R |

Le présent rapport de recherche a été établi pour toutes les revendications

| Lieu de la recherche | Date d'achèvement de la recherche | Examinateur |
|---|---|---|
| La Haye | 20 décembre 90 | DAVID J.Y.H. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire
T : théorie ou principe à la base de l'invention

E : document de brevet antérieur, mais publié à la date de dépôt ou après cette date
D : cité dans la demande
L : cité pour d'autres raisons

 

& : membre de la même famille, document correspondant